(19) Europäisches Patentamt / European Patent Office / Office européen des brevets

(11) **EP 3 381 249 B1**

(12) **EUROPÄISCHE PATENTSCHRIFT**

(45) Veröffentlichungstag und Bekanntmachung des Hinweises auf die Patenterteilung:
**05.01.2022   Patentblatt 2022/01**

(21) Anmeldenummer: **16709409.3**

(22) Anmeldetag: **10.03.2016**

(51) Int Cl.:
**H05K 13/08** (2006.01)

(86) Internationale Anmeldenummer:
**PCT/EP2016/055140**

(87) Internationale Veröffentlichungsnummer:
**WO 2017/152981 (14.09.2017 Gazette 2017/37)**

(54) **COMPUTERGESTÜTZTES VERFAHREN UND VORRICHTUNG ZUR ZUORDNUNG VON BAUGRUPPEN AUF BESTÜCKUNGSLINIEN**

COMPUTER IMPLEMENTED METHOD AND DEVICE FOR ALLOCATING ASSEMBLIES TO PLACEMENT LINES

PROCÉDÉ ASSISTÉ PAR ORDINATEUR ET DISPOSITIF D'ATTRIBUTION DE MODULES À DES LIGNES DE PLACEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**03.10.2018   Patentblatt 2018/40**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
**EP-A1- 2 894 528          WO-A1-2014/005744**
**DE-A1-102008 020 167    DE-B4-102011 076 565**

**Beschreibung**

Die vorliegende Erfindung betrifft ein computergestütztes Verfahren zur Zuordnung von Baugruppen auf Bestückungslinien zur Bestückung der Baugruppen mit Bauelementen. Weiterhin betrifft die Erfindung eine Vorrichtung für eine Fertigungs- oder Montagelinie zur Bestückung von Baugruppen mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Ein Hersteller von SMT- Bestückungsautomaten und -systeme mit dem Produktnamen SIPLACE ist beispielsweise die Firma ASM (http://www.siplace.com/en/Home).

Auf Grund von technischen Restriktionen kann aber nicht jede Baugruppe auf jeder Bestückungslinie gefertigt werden. Die Baugruppen besitzen auf den Bestückungslinien meist auch unterschiedliche Produktionszeiten. Zudem dürfen die maximalen Produktionszeitkapazitäten der Bestückungslinien nicht überschritten werden.

Die Zuordnung von Baugruppen auf Bestückungslinien eines Bestückungssystems erfolgt üblicherweise manuell oder halbautomatisch, basierend auf Erfahrungswerten oder Heuristiken.

Aus DE 10 2008 020 167 A1 ist ein Verfahren zum Bestimmen einer optimalen Zuordnung von einem zu fertigenden Produkt zu einer ausgewählten Produktionslinie von einer Mehrzahl von unterschiedlich konfigurierten Produktionslinien beschrieben. Das Verfahren weist auf (a) ein Berechnen der jeweiligen Produktionsdauern für das Produkt für jede Produktionslinie, und (b) ein Auswählen der ausgewählten Produktionslinie, basierend auf den berechneten Produktionsdauern. Dabei werden die jeweiligen Produktionsdauern unter Verwendung eines Ablaufgenerators berechnet, bei dem mehrere für die Fertigung des Produkts erforderliche Handhabungsschritte der jeweiligen Produktionslinie in eine geeignete zeitliche Abfolge gesetzt werden.

Aus EP 284 528 A1 ist ein Produktionslinienmanagementsystem bekannt. Es registriert und verwaltet in einheitlicher Weise Verteilungsdaten für jede Produktionsline. Es ermöglicht die Handhabung von einer kleinen Menge von Daten mit Hilfe eines Identifiers, der den Daten zugefügt wird, und vereinfacht die Systemkonfiguration.

Bei einem möglichen Einsatz von mathematischen Optimierungsmethoden sind lineare Optimierungsmethoden bzw. -verfahren möglich. Die lineare Optimierung befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MIP (mixed integer linear programming bzw. gemischt ganzzahlige Lineare Programmierung) können für kleine IP-Programme (ganzzahlige Optimierungsmodelle) Standardsolver wie z.B. CPLEX, Gurobi, Ilog, Xpress verwendet werden. Als kleine IP-Programme sind beispielsweise Instanzen mit 2 Linien, 181 Baugruppen und 839 Bauelementtypen denkbar. Bei größeren Instanzen können mit Standardsolvern wie CPLEX Probleme auftreten, diese komplexere Problemstellung zu lösen.

Da der Planungshorizont in der Fertigung meist mittelfristig ist, gibt es Unsicherheiten hinsichtlich der zukünftigen Stückzahlen der unterschiedlichen Baugruppentypen. Dies kann zu unerwünscht starken Schwankungen der Auslastungen/ Produktionszeiten der Bestückungslinien führen. Deshalb ist es in der Praxis erwünscht, Baugruppen-Linien-Zuordnungen zu vermeiden, mit denen bei einzelnen Linien besonders hohe Produktionszeitschwankungen auftreten können. Dies kann zur Folge haben, dass die entsprechenden Linien oft überlastet oder unterlastet sind.

Da die Produktionszeiten bei den oben genannten Methoden in den Nebenbedingungen mitberücksichtigt werden sollen, werden bei den heuristischen Verfahren üblicherweise fiktive Annahmen bei den Werten wie z.B. der Produktionszeitbeschränkungen ab- bzw. hergeleitet. Dies läuft in der Regel in einer Art "Trial and Error" ab und kann letztendlich sehr rechenintensiv sein.

Es ist Aufgabe der vorliegenden Erfindung, eine verbesserte Optimierungsmethode bzw. -technik zur Zuordnung von Baugruppen auf Bestückungslinien bereitzustellen.

Diese Aufgabe wird durch die unabhängigen Ansprüche gelöst. Vorteilhafte Weiterbildungen sind Gegenstand der abhängigen Ansprüche.

Die Erfindung beansprucht ein computergestütztes Verfahren zur Zuordnung von Baugruppen auf Bestückungslinien zur Bestückung der Baugruppen mit Bauelementen, wobei für jeden Baugruppentyp der zu bestückenden Baugruppen und jede Bestückungslinie unter Berücksichtigung der jeweiligen Taktzeit des Baugruppentyps auf der Bestückungslinie und der pro Baugruppentyp erwarteten zu produzierenden Stückzahl eine erwartete Produktionszeit ermittelt wird, wobei die tatsächliche zu produzierende Stückzahl gemäß einer vorher bestimmbaren Wahrscheinlichkeitsverteilung auftritt, wobei die möglichen Zuordnungen von Baugruppen auf Bestückungslinien durch die vorhandene Infrastruktur und/oder durch benutzerdefinierte Vorgaben eingeschränkt und die Zuordnung der Baugruppen auf die Bestückungslinien mittels einer Optimierungsmethode berechnet wird, wobei die Berechnung der Zuordnung derart erfolgt, dass für die aus den genannten Wahrscheinlichkeitsverteilungen für die Stückzahlen resultierenden Wahrscheinlichkeitsverteilungen bezüglich der Summe der erwarteten Produktionszeiten pro Bestückungslinie die Abweichungen vom jeweiligen Erwartungswert dieser resultierenden Wahrscheinlichkeitsverteilungen minimiert werden. Die Abweichung von der Summe der erwarteten Produktionszeiten einer Bestückungslinie kann als Varianz derselben bezeichnet werden. Die Varianz pro Bestückungslinie kann bestimmt werden durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit.

Eine Ausführungsform der Erfindung ist die Minimierung der Summe der Abweichungen vom jeweiligen Erwartungswert.

Der Vorteil des erfindungsgemäßen Vorgehens liegt darin, dass nun auch Problemstellungen mit größeren Instanzen weniger rechenintensiv als eingangs beschrieben gelöst werden können.

Als Optimierungsmethode kann die sogenannte ganzzahlige Lineare Programmierung angewendet werden. Dadurch können kommerzielle Standardsolver eingesetzt werden.

Die genannten Abweichungen von den Erwartungswerten der resultierenden Wahrscheinlichkeitsverteilungen können ähnliche oder gleiche Werte annehmen. Ähnlich kann hierbei bedeuten, dass eine maximale Abweichung nach oben oder unten zugelassen wird. "Gleich" kann hierbei identisch bedeuten. Es sind jedoch bei (nahezu) gleichen Werten auch geringe Ungenauigkeiten in Form von geringfügigen Abweichungen nach oben oder unten möglich, wobei im Gegensatz zu "ähnlich" solch eine geringfügige Abweichung kaum planbar und somit kaum vorbestimmbar ist.

Für die einer Bestückungslinie zugeordneten Menge von Baugruppen sollte die Summe der erwarteten Produktionszeiten eine maximale zeitliche Auslastung der jeweiligen Bestückungslinie nicht überschreiten.

Es kann sinnvoll sein, wenn jeder Baugruppentyp genau einer Bestückungslinie zugeordnet wird.

Die genannte Varianz ist auf einen vorgebbaren maximalen Schwellwert begrenzbar und kann ggf. durch Vorgabe eines maximalen Schwellwertes, im nachstehend beschriebenen Ausführungsbeispiel als $VarMax_l$ bezeichnet, minimiert werden.

Der maximale Schwellwert kann dabei in Form eines nach oben und/oder nach unten begrenzten Intervalls vorgegeben werden.

Die Weite des Intervalls kann prozentual in Abhängigkeit eines der das Intervall begrenzenden Werte festgelegt werden.

Als Eingabedaten für die ganzzahlige Lineare Programmierung können folgende, die Infrastruktur beschreibende Daten verwendet werden:

- Anzahl der Bestücklinien,
- Anzahl der Baugruppen,
- Anzahl der Baugruppentypen,- erwartete Stückzahl der Baugruppentypen pro Bestücklinie,
- Produktionszeitschranke pro jeweiliger Bestücklinie,
- Taktzeit des Baugruppentyps auf der Bestückungslinie und-Wahrscheinlichkeitsverteilungen für die erwarteten Stückzahlen der Baugruppentypen.

Eine Rüstfamilie ist bestimmt als eine Menge von Baugruppen, die auf einer Bestückungslinie bestückt werden können, ohne die Menge der Bauelementetypen zu ändern, die an der Bestückungslinie für die Bestückung bereit gehalten sind. Die Menge der an der Bestückungslinie bereit gehaltenen Bauelementetypen wird auch Rüstung genannt. Üblicherweise sind einer Bestückungslinie mehr Baugruppen zugeordnet als von einer Rüstfamilie umfasst sein können, da an der Bestückungslinie nicht beliebig viele Bauelementetypen bereit gehalten werden können. Die Bestückungslinie wird daher gelegentlich einem Rüstwechsel unterzogen, bei dem die Rüstung für eine erste Rüstfamilie gegen die Rüstung für eine zweite Rüstfamilie gewechselt wird. Je seltener diese Rüstwechsel sind und je weniger Bauelementetypen bei einem Rüstwechsel gewechselt werden müssen, desto weniger zeitaufwendig kann das Bestückungssystem betrieben werden. Die Anzahl der insgesamt im Bestückungssystem verwendeten Rüstfamilien kann einen realistischeren Qualitätsindikator als beispielsweise die Bauelementevarianz einer Bestückungsline darstellen. Die Bauelementevarianz einer Bestückungslinie ist dabei durch die Anzahl unterschiedlicher Bauelementetypen gegeben, deren Bauelemente auf eine der Baugruppen zu bestücken sind, die der Bestückungslinie zugeordnet sind. Das Verfahren kann daher Zuordnungen von Baugruppen an Bestückungslinien bestimmen, die eine verbesserte Auslastung des gesamten Bestückungssystems erlauben.

Während das beanspruchte Verfahren eine erste Zielfunktion der Optimierungsmethode definiert, die zum möglichst besten Ergebnis bezüglich der Abweichungen vom jeweiligen Erwartungswert hin konvergieren soll, kann das beanspruchte Verfahren zusätzlich mit einer zweiten Zielfunktion ergänzt werden. Diese zweite Zielfunktion kann auf Basis der vorstehend erläuterten Zuordnung die Anzahl der Rüstfamilien für jede Bestückungslinie bestimmen, wobei diese Anzahl an den Bestückungslinien möglichst gering sein soll, um den zeitlichen Umrüstaufwand zu reduzieren. Zur Begrenzung und/oder Minimierung der Anzahl der Rüstfamilien jeder Bestückungslinie können ggf. unterschiedliche Schwellwerte pro Bestückungslinien vorgegeben bzw. vorbestimmbar sein.

Mit weiteren Restriktionen wie der Bauelementvarianz und/oder der Anzahl der Rüstfamilien in der zweiten Zielfunktion ist es möglich, immer genauere Ergebnisse zu erzielen, die dazu beitragen, dass die maximale Auslastung der Bestückungslinien nicht überschritten wird.

Der Benutzer kann manuell vorgeben, ob bei der Gesamtoptimierung mit beiden Zielfunktionen mehr Gewicht auf die erste Zielfunktion oder mehr Gewicht auf die zweite Zielfunktion gelegt werden soll.

Ein weiterer Aspekt der Erfindung sieht eine Vorrichtung zur Zuordnung von Baugruppen auf Bestückungslinien zur Bestückung der Baugruppen mit Bauelementen, aufweisend:

- eine Einheit zum Ermitteln einer erwarteten Produktionszeit für jeden Baugruppentyp der zu bestückenden Baugruppen und für jede Bestückungslinie unter Berücksichtigung der jeweiligen Taktzeit des Baugruppentyps auf der Bestückungslinie und der pro Baugruppentyp erwarteten zu produzierenden Stückzahl, wobei die tatsächliche zu produzierende Stückzahl gemäß einer vorher bestimmbaren Wahrscheinlichkeitsverteilung auftreten kann, wobei die möglichen Zuordnungen von Baugruppen auf Bestückungslinien durch die vorhandene Infrastruktur und/oder durch benutzerdefinierte Vorgaben eingeschränkt werden kann, und

eine Einheit zum Berechnen der Zuordnung der Baugruppen auf die Bestückungslinien mittels einer Optimierungsmethode, wobei die Berechnung der Zuordnung derart erfolgt, dass für die aus den genannten Wahrscheinlichkeitsverteilungen für die Stückzahlen resultierenden Wahrscheinlichkeitsverteilungen bezüglich der Summe der erwarteten Produktionszeiten pro Bestückungslinie die Abweichungen vom jeweiligen Erwartungswert dieser resultierenden Wahrscheinlichkeitsverteilungen minimiert werden, wobei eine Abweichung von der Summe der erwarteten Produktionszeiten einer Bestückungslinie die Varianz derselben ist, welche pro Bestückungslinie durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit bestimmt werden kann.

Die Vorrichtung kann Mittel und/oder Einheiten bzw. Einrichtungen und/oder Module zur Durchführung des oben genannten Verfahrens vorsehen, die jeweils hardwaremäßig und/oder firmwaremäßig und/oder softwaremäßig bzw. als Computerprogramm bzw. Computerprogrammprodukt ausgeprägt sein können.

Die Vorrichtung kann wie das oben beschriebene Verfahren entsprechend weitergebildet werden.

Ein weiterer Aspekt der Erfindung sieht eine Fertigungs- oder Montagelinienanordnung zur Bestückung von Baugruppen mit Bauelementen, wobei die Zuordnung der Baugruppen auf die Fertigungs- oder Montagelinie gemäß dem vorstehend erläuterten Verfahren bestimmt wird.

Diese Fertigungs- oder Montagelinienanordnung kann Teil einer Anlage sein.

Die Anlage kann unter anderem durch einen der folgenden Anlagentypen charakterisiert sein. Beispiele hierfür sind:

- eine Automatisierungsanlage,
- eine Fertigungs- bzw. Produktionsanlage,
- eine Reinigungsanlage,
- eine Wasseraufbereitungsanlage,
- ein Gerät oder eine Maschine,
- eine Strömungsmaschine,
- eine Energieerzeugungsanlage,
- ein Energienetz,
- ein Kommunikationsnetz,
- eine medizintechnische Einrichtung bzw. Gerät,
- ein Krankenhausinformationssystem.

Ein weiterer Aspekt der Erfindung ist ein Computerprogrammprodukt bzw. ein Computerprogramm mit Mitteln zur Durchführung des oben genannten Verfahrens, wenn das Computerprogramm(-produkt) in einer oben genannten Vorrichtung zur Ausführung gebracht wird.

Das Computerprogramm bzw. -produkt kann auf einem computerlesbaren Medium gespeichert sein. Das Computerprogramm bzw. - produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Vorrichtung oder in deren Mitteln integriert sein.

Weitere Vorteile, Einzelheiten und Weiterbildungen der Erfindung ergeben sich aus der nachfolgenden Beschreibung von Ausführungsbeispielen in Verbindung mit den Zeichnungen.

Es zeigen

FIG 1 ein erstes beispielhaftes Montagewerk mit Bestückungslinien zur Baugruppenfertigung,

FIG 2 eine Graphik für die Wahrscheinlichkeitsverteilungen hinsichtlich der Stückzahlen/Produktionszeiten der Linien 1 und 2 für eine Baugruppen-Linien-Zuordnung, und

FIG 3 eine Graphik für die besagten Wahrscheinlichkeitsverteilungen nach dem erfindungsgemäßen Optimierungsansatz für eine Baugruppen-Linien-Zuordnung.

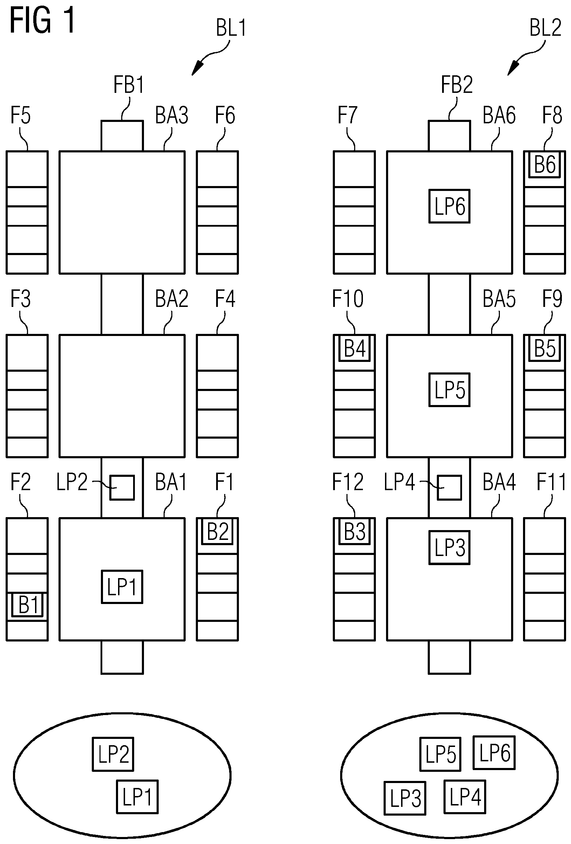

Figur 1 zeigt ein erstes beispielhaftes Montagewerk bzw. eine Montageanlage mit Bestückungslinien BL1 - BL2 zur Baugruppenfertigung. Eine Bestückungslinie BL1 - BL2 besteht üblicherweise aus Bestückungsautomaten BA1 - BA6, die jeweils durch ein Transportsystem FB1 - FB2 (z.B. Förderbänder) zum Transport der zu bestückenden Baugruppen LP1 - LP6 mit einander verbunden sind. Die auf die Baugruppen LP1 - LP6 zu bestückenden Bauelemente bzw. Bauteile B1 - B6 werden üblicherweise über Förderer F1 - F11 an den Bestückungsautomaten BA1 - BA6 bereitgestellt. Dabei kann einer Bestückungslinie BL1, BL2 mehrere Baugruppen LP1 - LP6 von einem bestimmten Baugruppentyp r aus einer Menge von Baugruppentypen R ($r \in R$) zugeordnet werden.

Bei Bestückungsautomaten BA1 - BA6 z.B. zum Bestücken von Substraten mit Bauelementen B1 - B6 sind seitlich an einer Transportstrecke für die Substrate Zuführvorrichtungen F1 - F11 für Bauelemente B1 - B6 angeordnet. Ein durch ein Positioniersystem verfahrbarer Bestückungskopf des Bestückungsautomaten BA1 - BA6 holt die Bauelemente B1 - B6 von den Zuführvorrichtungen F1 - F11 ab, verfährt diese zu einem Bestückungsbereich des Bestückungsautomaten, in dem das zu bestückende Substrat bereitgestellt ist, und setzt die Bauelemente B1 - B6 auf dem Substrat ab. Für die Bereitstellung der Bauelemente B1 - B6 werden z.B. sogenannte Gurt-Feeder eingesetzt, welche zum Transport und Zuführen von in Gurten gelagerten Bauteilen geeignet sind. Diese transportieren die in taschenartigen Vertiefungen magazinierten Bauteile zu einer Abholposition, an der die Bauteile von dem Bestückungskopf aus den Gurttaschen abgeholt werden. Der leere Gurt verlässt die Zuführvorrichtung F1 - F11 an einer geeigneten Stelle.

Im Folgenden werden als mathematische Optimierungsmethode IP-Modelle (IP steht für Integer Programmierung bzw. für Integer Programm oder ganzzahliges Optimierungsmodell) für diese Problemstellung beschrieben. Durch den Einsatz von exakten mathematischen Verfahren lassen sich deutlich bessere Lösungen erzielen als mit bisher verwendeten Heuristiken bzw. Optimierungsmethoden. IP-Lösungsansätze weisen folgende Vorteile auf:

- Globaler Optimierungsansatz
- Leicht erweiterbar
- Sehr gute kommerzielle Standard-Solver (z.B. Ilog, Xpress), die in der Praxis weit verbreitet und bewährt sind.
- Die Standard-Solver werden laufend verbessert, so dass zu erwarten ist das die Instanzen in Zukunft noch schneller lösbar sind.

Es können mit diesen Verfahren gute Produktionszeiten erreicht werden.

Im Planungszeitraum sollen auf mehreren SMT-Linien eine Menge von Baugruppen mit Bauelementen verschiedener Bauelementtypen bestückt werden. Für jede Baugruppe r wird geschätzt, wie viele Aufträge es dazu geben wird und wie oft sie insgesamt im Planungszeitraum gefertigt werden muss. Mit den Taktzeiten auf den verschiedenen (Bestückungs-)Linien, den geschätzten Umrüstzeiten und den Linien-Nutzungsgraden lassen sich geschätzte Gesamtproduktionszeiten pro Baugruppe und Linie ermitteln, die als Eingabe dienen können. Pro Linie wird zudem eine maximale Produktionszeit im Planungszeitraum vorgegeben. Die erwartete Produktionszeit pro Baugruppentyp kann mit einer in den Figuren nicht dargestellten Einheit ermittelt werden. Eine solche Einheit kann in einen Bestückungsautomaten z.B. BA1 der Bestückungslinie BL1 integriert sein. Auch eine nicht dargestellte Einheit zum Berechnen der Zuordnung der Baugruppen auf Bestückungslinien kann in solchen einen Bestückungsautomaten integriert sein.

Diese Einheiten können auch in einen separiert von den Bestückungsautomaten stehenden Computer implementiert bzw. integriert sein, der die Bestückungsautomaten steuert.

Das dargestellte IP-Modell ist nur als eine mögliche beispielhafte Formulierung anzusehen und stellt keine Einschränkung für das Verfahren dar.

Ziel ist es, Produktionszeitschwankungen der einzelnen Linien zu beschränken oder diese so weit wie möglich zu minimieren.

Im Ausführungsbeispiel werden folgende Parameter im IP-Modell verwendet:

Es sei $L$ die Menge aller (Bestückungs-)Linien und $R$ die Menge aller Baugruppentypen und $R_l$ die Menge der bestückbaren Baugruppentypen auf Line l.

Weitere Parameter sind:

$n_r$ Unabhängige Zufallsvariable für die zu produzierende Stückzahl n des Baugruppentyps r innerhalb eines bestimmten Zeitraums

$c_r$ Fixe Produktionszeit bei der Produktion einer beliebigen Stückzahl des Baugruppentyps r

EP 3 381 249 B1

$t_{r,l}$        Taktzeit für die Produktion einer Baugruppe des Baugruppentyps r an Linie *l*

*VarMax_l*        Maximale Produktionszeit-Varianz auf der Bestücklinie *l*

*TimeLimit_l*        Produktionszeitschranke auf der Bestücklinie *l*

*Assign_{r,l}*        Zuordnung des Baugruppentyps r zu Bestücklinie *l*

Es wird angenommen, die Produktionszeit einer Baugruppe auf einer Linie $t_{r,l}n_r + c_r$ beträgt. Dabei ist $c_r$ ein konstanter Anteil, in dem zum Beispiel die Umrüstzeiten enthalten sind.

Die Produktionszeiten der Baugruppe auf einer Linie sind auch unabhängige Zufallsvariablen.

Für eine Menge $R_l' \subseteq R_l$ von Baugruppentypen, die einer Linie *l* zugewiesen sind, ist die Produktionszeit folglich auch eine Zufallsvariable, für dessen Varianz gilt:

$$Var(\text{Produktionszeit Linie } l) = Var\left(\sum_{r \in R_l'} t_{r,l}n_r + c_r\right)$$

$$= \sum_{r \in R_l'} t^2{}_{r,l}Var(n_r)$$

In einem IP-Modell werden in der Regel Restriktionen verwendet. Folgende Restriktionen des IP-Modells beschränken die erwartete Produktionszeit auf den Linien und gewährleisten die Zulässigkeit der Lösung:

$$\sum_{r \in R} EW\left(t_{r,l}n_r + c_r\right) Assign_{r,l} \leq TimeLimit_l \qquad\qquad l \in L$$

Die Restriktionen

$$Assign_{r,l} = 0 \qquad\qquad l \in L, r \in R\backslash R_l$$

garantieren, dass Baugruppen nur Bestückungslinien zugewiesen werden können, auf denen sie auch bestückbar sind.

Durch die Restriktionen

$$\sum_{l \in L} Assign_{r,l} = 1 \qquad\qquad r \in R$$

wird jeder Baugruppentyp genau einer Bestückungslinie zugeordnet.

Im IP-Modell lässt sich zudem die Produktionszeit-Varianz einer Bestückungslinie folgendermaßen ausdrücken:

$$Var(\text{Produktionszeit Linie } l) = \sum_{r \in R_l} t_{r,l}^2 Var(n_r) Assign_{r,l} \qquad\qquad l \in L$$

Es sind folgende Varianten zur Begrenzung der maximalen Produktionszeit-Varianz auf den Linien möglich:

(1) Durch fest vorgegebene Parameter *VarMax_l* lassen sich die Produktionszeitvarianzen für alle Linien *l* begrenzen durch die zusätzlichen Restriktionen

$$\sum_{r \in R_l} t_{r,l}^2 Var(n_r) Assign_{r,l} \leq VarMax_l \qquad\qquad l \in L$$

(2) Wird *VarMax_l* als Variable gewählt, so kann mit einer Hilfsvariable $V_{max}$ und zusätzlichen Restriktionen

$$VarMax_l \leq V_{max} \qquad\qquad l \in L$$

durch Minimierung von $V_{max}$ erreicht werden, dass die maximale Produktionszeitvarianz der Linien so weit wie möglich minimiert wird. $V_{max}$ kann dabei mit einem Gewichtsfaktor w in die Zielfunktion des IP-Modells aufgenommen werden.

(3) Eine weitere Möglichkeit ist, für einen vorgegebenen Prozentwert p, die Abweichung der maximalen und der minimalen Varianz der Linien zu beschränken.

Dazu sei $V_{min}$ eine weitere Hilfsvariable. Zusätzliche Restriktionen sind

$$V_{min} \leq VarMax_l \qquad\qquad l \in L$$

und

$$V_{max} - V_{min} \leq \frac{p}{100} V_{max}$$

Mit den oben dargestellten Restriktionen der Varianten (1) und (3) kann zudem jeweils das IP-Modell aus DE 10 2011 076 565 B4, WO2014/005741 A1, WO2014/005743 A1, WO2014/005744 A1 erweitert werden. Die aus den genannten Dokumenten bekannten Methoden sind Beispiele für Optimierungsmethoden mittels MIP für Zuordnungen von Baugruppen auf Bestückungslinien.

In der Patentanmeldung "Verfahren und Vorrichtung zur Zuordnung von Baugruppen auf Bestückungslinien" mit dem gleichen Zeitrang wie die vorliegende Patentanmeldung ist die oben genannte Erweiterung offenbart.

Demnach können auch in diesen IP-Modellen Produktionszeitschwankungen eingeschränkt werden. Mit der Variante (2) können diese IP-Modelle ebenfalls erweitert werden, indem zusätzlich zu den neuen Restriktionen V_{max} mit einer gewählten Gewichtung in die Zielfunktion mit aufgenommen wird.

Die ganzzahlige lineare Programmierung kann durch folgende Schritte gelöst wird:

a) Ermitteln einer Startlösung bzw. ersten aktuellen Lösung,

b) Zuordnen von einer ausgewählten Menge von Baugruppen LP1 - L6 auf die Bestückungslinien BL1 - BL2, basierend auf einer aktuellen Lösung,

c) Berechnen der neuen Zuordnungen mittels eines Optimierungsprogrammes oder eines Standardsolvers basierend auf ganzzahliger linearer Programmierung.

Die Schritte können iterativ durchgeführt werden und ein Programmabbruch erfolgt, wenn eine vorher festgelegte Zeitgrenze oder Ergebnisgüte erreicht wird.

Im Folgenden wird ein vereinfachtes Beispiel erläutert, das den oben komplex dargestellten Optimierungsprozess zum Verständnis in vereinfachter Weise erläutern soll, ohne auf dieses vereinfachtes Beispiel beschränkt zu sein. Überträgt man das nachstehend beschriebene einfache Beispiel mit wenigen Instanzen auf größere Instanzen bzw. komplexere Problemstellungen ist eine gute bzw. genaue Auswahl an Parametern im IP-Modell mit den anzuwendenden Restriktionen bzw. den benutzerdefinierten Vorgaben wesentlich, um eine Lösung der komplexen Problemstellung mit den erwähnten Standardsolvern überhaupt erzielen zu können.

Es wird im folgenden Beispiel angenommen, dass für einen Baugruppentyp bei einer prognostizierten Stückzahl n die tatsächlich zu fertigende bzw. zu bestückenden Stückzahl gemäß der folgenden Wahrscheinlichkeitsverteilung schwankt:

• Mit einer Wahrscheinlichkeit von 0,8 wird der prognostizierte Wert n angenommen.

• Mit einer Wahrscheinlichkeit von jeweils 0,1 wird eine 10%ige Abweichung des Wertes n nach oben bzw. unten angenommen.

Es sollen sechs verschiedene Baugruppentypen zu zwei Linien BL 1 und BL 2 zugeordnet werden. Die prognostizierten Stückzahlen n sind:

| r1 | r2 | r3 | r4 | r5 | r6 |
|------|------|------|------|------|------|
| 2000 | 2000 | 1000 | 1000 | 1000 | 1000 |

Die Zuordnung soll so erfolgen, dass die beiden Linien gleich ausgelastet sind, d.h. gleiche erwartete Produktionszeiten.

Die Taktzeiten betragen für allen Baugruppentypen 1 min, somit beträgt z.B. die Produktionszeit 1000 min bei einer Stückzahl von 1000.

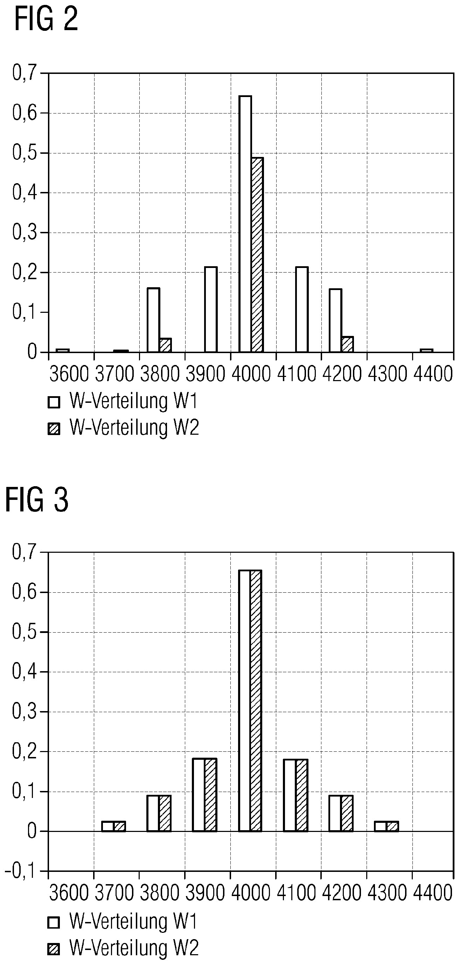

Als mögliche Startlösung können r1 und r2 auf die Linie BL1 und die Baugruppen r3 bis r6 auf die Linie BL2 zugeordnet werden. So ergeben sich folgende WahrscheinlichkeitsVerteilungen W1 und W2 der Stückzahlen/Produktionszeiten auf beiden Linien BL1 und BL2, wie es in folgender Tabelle bzw. in Figur 2 dargestellt ist.

|      | W-Verteilung von BL1 | W-Verteilung von BL2 |
|------|------|------|
| 3600 | 0,01 | 0,0001 |
| 3700 |      | 0,0032 |
| 3800 | 0,16 | 0,0388 |
| 3900 |      | 0,2144 |
| 4000 | 0,64 | 0,487 |
| 4100 |      | 0,2144 |
| 4200 | 0,16 | 0,0388 |
| 4300 |      | 0,0032 |
| 4400 | 0,01 | 0,0001 |

Auf Linie BL1 ergibt sich durch die beiden Baugruppentypen mit hohen Stückzahlen eine hohe Schwankungsbreite für die Stückzahlen/Produktions zeiten.

Werden die beiden Baugruppentypen r1 und r2 hingegen auf die Linien BL1 und BL2 aufgeteilt, so ergibt sich folgende Wahrscheinlichkeits-Verteilungen W1 und W2 der Stückzahlen/Produktionszeiten auf den beiden Linien BL1 und BL2, wie es in der folgenden Tabelle und in Figur 3 dargestellt ist.

|      | W-Verteilung von BL1 | W-Verteilung von BL2 |
|------|------|------|
| 3600 | 0,001 | 0,001 |
| 3700 | 0,016 | 0,016 |
| 3800 | 0,074 | 0,074 |
| 3900 | 0,144 | 0,144 |
| 4000 | 0,53 | 0,53 |
| 4100 | 0,144 | 0,144 |
| 4200 | 0,074 | 0,074 |
| 4300 | 0,016 | 0,016 |
| 4400 | 0,001 | 0,001 |

Die maximale Varianz beträgt bei der ersten Zuordnung

$$2 * (400^2 * 0,01 + 200^2 * 0,16) = 16000$$

und verringert sich bei der zweiten Zuordnung um 25% auf

$$2 * (400^2 * 0,001 + 300^2 * 0,016 + 200^2 * 0,074 + 100^2 * 0,144) = 12000$$

In der Mitte und am Rand sind die Werte der Verteilungen für Linie BL1 und Linie BL2 bei der zweiten Baugruppenlinien-Zuordnung deutlich niedriger als die Werte der Verteilung für Linie BL1 bei der ersten Baugruppenlinien-Zuordnung. Am Rand ist die Wahrscheinlichkeit sogar nur noch ein Zehntel.

Bei einer geeigneten Parameterwahl kann gezielt die oben erläuterte zweite Baugruppenlinien-Zuordnung ermittelt werden. Die Schritte der Optimierung können iterativ durchgeführt werden und ein Programmabbruch kann erfolgen, wenn eine zuvor festgelegte Zeitgrenze oder eine vorgebbare Ergebnisgüte erreicht wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1.   Computergestütztes Verfahren zur Zuordnung von Baugruppen (LP1 - LP6) auf Bestückungslinien (BL1 - BL2) zur Bestückung der Baugruppen (LP1 - LP6) mit Bauelementen (B1 - B6), wobei für jeden Baugruppentyp der zu bestückenden Baugruppen (LP1 - LP6) und jede Bestückungslinie (BL1 - BL2) unter Berücksichtigung der jeweiligen Taktzeit des Baugruppentyps auf der Bestückungslinie (BL1 - BL2) und der pro Baugruppentyp erwarteten zu produzierenden Stückzahl eine erwartete Produktionszeit ermittelt wird, wobei die tatsächliche zu produzierende Stückzahl gemäß einer vorher bestimmbaren Wahrscheinlichkeitsverteilung auftritt, wobei die möglichen Zuordnungen von Baugruppen (LP1 - LP6) auf Bestückungslinien (BL1 - BL2) durch die vorhandene Infrastruktur und/oder durch benutzerdefinierte Vorgaben eingeschränkt und die Zuordnung der Baugruppen (LP1 - LP6) auf die Bestückungslinien (BL1 - BL2) mittels einer Optimierungsmethode berechnet wird, wobei die Berechnung der Zuordnung derart erfolgt, dass für die aus den genannten Wahrscheinlichkeitsverteilungen für die Stückzahlen resultierenden Wahrscheinlichkeitsverteilungen bezüglich der Summe der erwarteten Produktionszeiten pro Bestückungslinie (BL1; BL2) die Abweichungen vom jeweiligen Erwartungswert dieser resultierenden Wahrscheinlichkeitsverteilungen minimiert werden, wobei eine Abweichung von der Summe der erwarteten Produktionszeiten einer Bestückungslinie als Varianz derselben bezeichnet wird, welche pro Bestückungslinie durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit bestimmt werden kann.

2.   Computergestütztes Verfahren nach dem vorhergehenden Anspruch, **dadurch gekennzeichnet, dass** die genannten Abweichungen von den Erwartungswerten der resultierenden Wahrscheinlichkeitsverteilungen ähnliche oder gleiche Werte annehmen.

3.   Computergestütztes Verfahren nach einem der vorhergehenden Ansprüche, **dadurch gekennzeichnet, dass** für die einer Bestückungslinie (BL1 - BL2) zugeordneten Menge von Baugruppen (LP1 - LP6) die Summe der erwarteten Produktionszeiten eine maximale zeitliche Auslastung der jeweiligen Bestückungslinie (BL1 - BL2) nicht überschreiten darf.

4.   Computergestütztes Verfahren nach einem der vorhergehenden Ansprüche, **dadurch gekennzeichnet, dass** als Optimierungsmethode die sogenannte ganzzahlige Lineare Programmierung angewendet wird.

5.   Computergestütztes Verfahren nach einem der vorhergehenden Ansprüche, **dadurch gekennzeichnet, dass** die Abweichung von der Summe der erwarteten Produktionszeiten einer Bestückungslinie auf einen vorgebbaren maximalen Schwellwert begrenzt wird.

6.   Computergestütztes Verfahren nach dem vorhergehenden Anspruch, **dadurch gekennzeichnet, dass** der genannte maximale Schwellwert minimiert wird.

**7.** Computergestütztes Verfahren nach dem vorhergehenden Anspruch 5 oder 6, **dadurch gekennzeichnet, dass** der maximale Schwellwert in Form eines nach oben und/oder nach unten begrenzten Intervalls vorgegeben wird.

**8.** Computergestütztes Verfahren nach dem vorhergehenden Anspruch, **dadurch gekennzeichnet, dass** die Weite des Intervalls prozentual in Abhängigkeit eines der das Intervall begrenzenden Werte festgelegt wird.

**9.** Computergestütztes Verfahren nach einem der vorhergehenden Ansprüche, **dadurch gekennzeichnet, dass** jeder Baugruppentyp genau einer Bestückungslinie (BL1, BL2) zugeordnet wird.

**10.** Vorrichtung zur Zuordnung von Baugruppen (LP1 - LP6) auf Bestückungslinien (BL1 - BL2) zur Bestückung der Baugruppen (LP1 - LP6) mit Bauelementen (B1 - B6), aufweisend:

- eine Einheit zum Ermitteln einer erwarteten Produktionszeit für jeden Baugruppentyp der zu bestückenden Baugruppen (LP1 - LP6) und für jede Bestückungslinie (BL1 - BL2) unter Berücksichtigung der jeweiligen Taktzeit des Baugruppentyps auf der Bestückungslinie (BL1 - BL2) und der pro Baugruppentyp erwarteten zu produzierenden Stückzahl, wobei die tatsächliche zu produzierende Stückzahl gemäß einer vorher bestimmbaren Wahrscheinlichkeitsverteilung auftreten kann, wobei die möglichen Zuordnungen von Baugruppen (LP1 - LP6) auf Bestückungslinien (BL1 - BL2) durch die vorhandene Infrastruktur und/oder durch benutzerdefinierte Vorgaben eingeschränkt werden kann, und

- eine Einheit zum Berechnen der Zuordnung der Baugruppen (LP1 - LP6) auf die Bestückungslinien (BL1 - BL2) mittels einer Optimierungsmethode, wobei die Berechnung der Zuordnung derart erfolgt, dass für die aus den genannten Wahrscheinlichkeitsverteilungen für die Stückzahlen resultierenden Wahrscheinlichkeitsverteilungen bezüglich der Summe der erwarteten Produktionszeiten pro Bestückungslinie (BL1; BL2) die Abweichungen vom jeweiligen Erwartungswert dieser resultierenden Wahrscheinlichkeitsverteilungen minimiert werden,

wobei eine Abweichung von der Summe der erwarteten Produktionszeiten einer Bestückungslinie die Varianz derselben ist, welche pro Bestückungslinie durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit bestimmt werden kann.

**11.** Vorrichtung nach dem vorhergehenden Anspruch, **dadurch gekennzeichnet, dass** die genannten Abweichungen von den Erwartungswerten der resultierenden Wahrscheinlichkeitsverteilungen ähnliche oder gleiche Werte annehmen.

**12.** Vorrichtung nach einem der vorhergehenden Vorrichtungsansprüche, **dadurch gekennzeichnet, dass** für die einer Bestückungslinie (BL1 - BL2) zugeordneten Menge von Baugruppen (LP1 - LP6) die Summe der erwarteten Produktionszeiten eine maximale zeitliche Auslastung der jeweiligen Bestückungslinie (BL1 - BL2) nicht überschreiten darf.

**13.** Vorrichtung nach einem der vorhergehenden Vorrichtungsansprüche, **dadurch gekennzeichnet, dass** als Optimierungsmethode die sogenannte ganzzahlige Lineare Programmierung anwendbar ist.

**14.** Vorrichtung nach einem der vorhergehenden Vorrichtungsansprüche, **dadurch gekennzeichnet, dass** die genannte Abweichung von der Summe der erwarteten Produktionszeiten einer Bestückungslinie auf einen vorgebbaren maximalen Schwellwert begrenzbar ist.

**15.** Vorrichtung nach dem vorhergehenden Anspruch, **dadurch gekennzeichnet, dass** der genannte maximale Schwellwert minimierbar ist.

**16.** Vorrichtung nach dem vorhergehenden Anspruch 14 oder 15, **dadurch gekennzeichnet, dass** der maximale Schwellwert in Form eines nach oben und/oder nach unten begrenzten Intervalls vorgegeben ist.

**17.** Vorrichtung nach dem vorhergehenden Anspruch, **dadurch gekennzeichnet, dass** die Weite des Intervalls prozentual in Abhängigkeit eines der das Intervall begrenzenden Werte festgelegt ist.

**18.** Vorrichtung nach einem der vorhergehenden Vorrichtungsansprüche, **dadurch gekennzeichnet, dass** jeder Baugruppentyp genau einer Bestückungslinie (BL1, BL2) zugeordnet ist.

**19.** Computerprogramm mit Mitteln zur Durchführung des Verfahrens nach einem der vorgenannten Verfahrensansprüche, wenn das Computerprogramm auf einer Vorrichtung nach einem der vorgenannten Vorrichtungsansprüche zur Ausführung gebracht wird.

**20.** Computerlesbares Medium, umfassend Anweisungen, welche, wenn sie auf der Vorrichtung nach einem der vorhergehenden Vorrichtungsansprüche ausgeführt werden, die Vorrichtung dazu bringen, das Verfahren gemäß einem der vorhergehenden Verfahrensansprüche auszuführen.

**Claims**

**1.** Computer-aided method for assigning assemblies (LP1 - LP6) to component fitting lines (BL1 - BL2) for fitting the assemblies (LP1 - LP6) with components (B1 - B6), wherein an expected production time is ascertained for each assembly type of the assemblies (LP1 - LP6) to be fitted with components and each component fitting line (BL1 - BL2) taking into consideration the respective cycle time for the assembly type on the component fitting line (BL1 - BL2), and the expected number of items to be produced per assembly type, wherein the actual number of items to be produced arises according to a previously determinable probability distribution, wherein the possible assignments of assemblies (LP1 - LP6) to component fitting lines (BL1 - BL2) are limited by the existing infracture and/or by user-defined presets, and the assignment of the assemblies (LP1 - LP6) to the component fitting lines (BL1 - BL2) is computed by means of an optimization method, wherein the assignment is computed such that for the probability distributions with respect to the sum of the expected production times per component fitting line (BL1; BL2) that result from the cited probability distributions for the numbers of items, the differences from the respective expected value of these resultant probability distributions are minimized, wherein a difference from the sum of the expected production times of a component fitting line is described as a variance thereof, which can be determined per component fitting line by the sum over all assembly types assigned to the component fitting line, from the product of the squared difference from the expected number of items of an assembly type within a period of time and the associated values of the resultant probability distributions and with multiplication by the squared cycle time.

**2.** Computer-aided method according to the preceding claim, **characterized in that** the cited differences from the expected values of the resultant probability distributions assume similar or like values.

**3.** Computer-aided method according to either of the preceding claims, **characterized in that** the sum of the expected production times for the set of assemblies (LP1 - LP6) that is assigned to a component fitting line (BL1 - BL2) must not exceed a maximum utilization level of the respective component fitting line (BL1 - BL2) over time.

**4.** Computer-aided method according to one of the preceding claims, **characterized in that** the optimization method applied is what is known as integer linear programming.

**5.** Computer-aided method according to one of the preceding claims, **characterized in that** the difference from the sum of the expected production times of a component fitting line is limited to a prescribable maximum threshold value.

**6.** Computer-aided method according to the preceding claim, **characterized in that** the cited maximum threshold value is minimized.

**7.** Computer-aided method according to the preceding Claim 5 or 6, **characterized in that** the maximum threshold value is prescribed in the form of an interval limited at the top and/or at the bottom.

**8.** Computer-aided method according to the preceding claim, **characterized in that** the width of the interval is stipulated as a percentage on the basis of one of the values limiting the interval.

**9.** Computer-aided method according to one of the preceding claims, **characterized in that** each assembly type is assigned to precisely one component fitting line (BL1, BL2) .

**10.** Apparatus for assigning assemblies (LP1 - LP6) to component fitting lines (BL1 - BL2) for fitting the assemblies (LP1 - LP6) with components (B1 - B6), having:

- a unit for ascertaining an expected production time for each assembly type of the assemblies (LP1 - LP6) to be fitted with components and for each component fitting line (BL1 - BL2) taking into consideration the respective cycle time for the assembly type on the component fitting line (BL1 - BL2) and the expected number of items to be produced per assembly type, wherein the actual number of items to be produced can arise according to a previously determinable probability distribution, wherein the possible assignments of assemblies (LP1 - LP6) to component fitting lines (BL1 - BL2) can be limited by the existing infrastructure and/or by user-defined presets, and

- a unit for computing the assignment of the assemblies (LP1 - LP6) to the component fitting lines (BL1 - BL2) by means of an optimization method, wherein the assignment is computed such that for the probability distributions with respect to the sum of the expected production times per component fitting line (BL1; BL2) that result from the cited probability distributions for the numbers of items, the differences from the respective expected value of these resultant probability distributions are minimized,

wherein a difference from the sum of the expected production times of a component fitting line is the variance thereof, which can be determined per component fitting line by the sum over all assembly types assigned to the component fitting line, from the product of the squared difference from the expected number of items of an assembly type within a period of time and the associated values of the resultant probability distributions and with multiplication by the squared cycle time.

11. Apparatus according to the preceding claim, **characterized in that** the cited differences from the expected values of the resultant probability distributions assume similar or like values.

12. Apparatus according to either of the preceding apparatus claims, **characterized in that** the sum of the expected production times for the set of assemblies (LP1 - LP6) that is assigned to a component fitting line (BL1 - BL2) must not exceed a maximum utilization level of the respective component fitting line (BL1 - BL2) over time.

13. Apparatus according to one of the preceding apparatus claims, **characterized in that** the optimization method able to be applied is what is known as integer linear programming.

14. Apparatus according to one of the preceding apparatus claims, **characterized in that** the cited difference from the sum of the expected production times of a component fitting line is limitable to a prescribable maximum threshold value.

15. Apparatus according to the preceding claim, **characterized in that** the cited maximum threshold value is minimizable.

16. Apparatus according to the preceding Claim 14 or 15, **characterized in that** the maximum threshold value is prescribed in the form of an interval limited at the top and/or at the bottom.

17. Apparatus according to the preceding claim, **characterized in that** the width of the interval is stipulated as a percentage on the basis of one of the values limiting the interval.

18. Apparatus according to one of the preceding apparatus claims, **characterized in that** each assembly type is assigned to precisely one component fitting line (BL1, BL2) .

19. Computer program having means for performing the method according to one of the aforementioned method claims when the computer program is executed on an apparatus according to one of the aforementioned apparatus claims.

20. Computer-readable medium, comprising instructions that, when executed on the apparatus according to one of the preceding apparatus claims, prompt the apparatus to perform the method according to one of the preceding method claims.

**Revendications**

1. Procédé informatisé destiné à l'association de modules (LP1 - LP6) sur des lignes de montage (BL1 - BL2) destinées au montage des modules (LP1 - LP6) avec des composants (B1 - B6), dans lequel pour chaque type de module des modules à monter (LP1 - LP6) et chaque ligne de montage (BL1 - BL2) en prenant en compte la durée de cycle respective du type de module sur la ligne de montage (BL1 - BL2) et du nombre de pièces à produire escompté par type de module une durée de production escomptée est déterminée, dans lequel le nombre de pièces à produire réel est conforme à une distribution de probabilité apte à être déterminée au préalable, dans lequel les associations possibles de modules (LP1 - LP6) sur des lignes de montage (BL1 - BL2) sont limitées par le biais de l'infrastructure présente et/ou par le biais de directives définies par l'utilisateur et l'association des modules (LP1-LP6) sur les lignes de montage (BL1 - BL2s) est calculée au moyen d'une méthode d'optimisation, dans lequel le calcul de l'association se fait de telle sorte que pour les distributions de probabilités résultant desdites distributions de probabilités pour les nombres de pièces en ce qui concerne la somme des durées de production escomptées par ligne de montage (BL1 ; BL2) les écarts de la valeur escomptée respective de ces distributions de probabilités résultantes sont diminués, dans lequel un écart de la somme des durées de production escomptées d'une ligne de montage est qualifié de variance de celles-ci, laquelle peut être déterminée par ligne de montage par le biais de la somme via tous les types de modules qui sont associés à la ligne de montage, à partir du produit de l'écart quadratique du nombre de pièces à escompter d'un type de module au sein d'une période et des valeurs connexes des distributions de probabilités résultantes et multiplié avec la durée de cycle au carré.

2.  Procédé informatisé selon la revendication précédente, **caractérisé en ce que** lesdits écarts des valeurs escomptées des distributions de probabilités résultantes prennent des valeurs similaires ou identiques.

3.  Procédé informatisé selon l'une quelconque des revendications précédentes, **caractérisé en ce que** pour la quantité de modules (LP1 - LP6) associée à une ligne de montage (BL1 - BL2) la somme des durées de production escomptées ne doit pas dépasser une utilisation dans le temps maximale de la ligne de montage respective (BL1 - BL2).

4.  Procédé informatisé selon l'une quelconque des revendications précédentes, **caractérisé en ce que**, en tant que méthode d'optimisation, ladite programmation linéaire à nombres entiers est utilisée.

5.  Procédé informatisé selon l'une quelconque des revendications précédentes, **caractérisé en ce que** l'écart de la somme des durées de production escomptées d'une ligne de montage est limitée à une valeur de seuil maximale apte à être prédéfinie.

6.  Procédé informatisé selon la revendication précédente, **caractérisé en ce que** ladite valeur de seuil maximale est diminuée.

7.  Procédé informatisé selon la revendication précédente 5 ou 6, **caractérisé en ce que** la valeur de seuil maximale est prédéfinie sous la forme d'un intervalle limité vers le haut et/ou vers le bas.

8.  Procédé informatisé selon la revendication précédente, **caractérisé en ce que** l'étendue de l'intervalle est définie en termes de pourcentages en fonction d'une valeur limitant l'intervalle.

9.  Procédé informatisé selon l'une quelconque des revendications précédentes, **caractérisé en ce que** chaque type de module est associé exactement à une ligne de montage (BL1, BL2).

10. Dispositif destiné à l'association de modules (LP1 - LP6) sur des lignes de montage (BL1 - BL2) destinées au montage des modules (LP1 - LP6) avec des éléments (B1 - B6), présentant :

    - une unité destinée à la détermination d'une durée de production escomptée pour chaque type de module des modules à monter (LP1 - LP6) et pour chaque ligne de montage (BL1 - BL2) en prenant en compte la durée de cycle respective du type de module sur la ligne de montage (BL1 - BL2) et le nombre de pièces à produire escompté par type de module, dans lequel le nombre de pièces à produire réel peut être conforme à une distribution de probabilités apte à être déterminée au préalable, dans lequel les associations possibles de modules (LP1 - LP6) sur des lignes de montage (BL1 - BL2) peuvent être limitées par le biais de l'infrastructure présente et/ou par le biais de directives définies par l'utilisateur, et
    - une unité destinée au calcul de l'association des modules (LP1 - LP6) sur les lignes de montage (BL1 - BL2) au moyen d'une méthode d'optimisation, dans lequel le calcul de l'association se fait de telle sorte que pour les distributions de probabilités résultant desdites distributions de probabilités pour les nombres de pièces en ce qui concerne la somme des durées de production escomptées par ligne de montage (BL1 ; BL2) les écarts de la valeur escomptée respective de ces distributions de probabilités résultantes sont diminués,

    dans lequel un écart de la somme des durées de production escomptées d'une ligne de montage est la variance de celles-ci, qui peut être déterminée par ligne de montage par le biais de la somme de tous les types de modules qui sont associés à la ligne de montage, à partir du produit de l'écart quadratique du nombre de pièces à escompter d'un type de module au sein d'une période et des valeurs connexes des distributions de probabilités et multipliée avec la durée de cycle au carré.

11. Dispositif selon la revendication précédente, **caractérisé en ce que** lesdits écarts des valeurs escomptées des distributions de probabilités résultantes prennent des valeurs similaires ou identiques.

12. Dispositif selon l'une quelconque des revendications de procédé précédentes, **caractérisé en ce que** pour la quantité de modules (LP1 - LP6) associée à une ligne de montage (BL1 - BL2) la somme des durées de production escomptées ne doit pas dépasser une utilisation dans le temps maximale de la ligne de montage respective (BL1 - BL2).

13. Dispositif selon l'une quelconque des revendications de procédé précédentes, **caractérisé en ce que**, en tant que méthode d'optimisation, ladite programmation linéaire à nombres entiers est utilisée.

14. Dispositif selon l'une quelconque des revendications de procédé précédentes, **caractérisé en ce que** ledit écart de la somme des durées de production escomptées d'une ligne de montage est apte à être limitée à une valeur de seuil maximale apte à être prédéfinie.

15. Dispositif selon la revendication précédente, **caractérisé en ce que** ladite valeur de seuil maximale est apte à être diminuée.

16. Dispositif selon l'une quelconque des revendications précédentes 14 ou 15, **caractérisé en ce que** la valeur de seuil maximale est prédéfinie sous la forme d'un intervalle limité vers le haut et/ou vers le bas.

17. Dispositif selon la revendication précédente, **caractérisé en ce que** l'étendue de l'intervalle est définie en termes de pourcentages en fonction d'une valeur limitant l'intervalle.

18. Dispositif selon l'une quelconque des revendications de procédé précédentes, **caractérisé en ce que** chaque type de module est associé exactement à une ligne de montage (BL1, BL2).

19. Programme informatique avec des moyens destinés à la réalisation du procédé selon l'une quelconque desdites revendications de procédé précédentes, lorsque le programme informatique est mis à exécution sur un dispositif selon l'une quelconque desdites revendications de dispositif.

20. Support lisible sur ordinateur, comprenant des instructions qui, lorsqu'elles sont exécutées sur le dispositif selon l'une quelconque des revendications de dispositif précédentes, amènent le dispositif à exécuter le procédé selon l'une quelconque des revendications de procédé précédentes.

FIG 1

## FIG 2

W-Verteilung W1
W-Verteilung W2

## FIG 3

W-Verteilung W1
W-Verteilung W2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102008020167 A1
- EP 284528 A1
- DE 102011076565 B4
- WO 2014005741 A1
- WO 2014005743 A1
- WO 2014005744 A1